(19) **Europäisches Patentamt**
**European Patent Office**
**Office européen des brevets**

(11) **EP 3 866 043 B1**

(12) **EUROPÄISCHE PATENTSCHRIFT**

(45) Veröffentlichungstag und Bekanntmachung des Hinweises auf die Patenterteilung:
**17.12.2025 Patentblatt 2025/51**

(51) Internationale Patentklassifikation (IPC):
**G06F 30/15** (2020.01)    **G06F 30/17** (2020.01)
**G06F 30/23** (2020.01)

(21) Anmeldenummer: **21153288.2**

(22) Anmeldetag: **25.01.2021**

(52) Gemeinsame Patentklassifikation (CPC):
**G06F 30/23; G06F 30/15; G06F 30/17**

(54) **KORREKTUR DER RÜCKFEDERUNG BEI DER HERSTELLUNG VON UMFORMTEILEN**

COMPENSATION FOR RESILIENCE DURING THE PRODUCTION OF SHAPED PARTS

CORRECTION DU RETOUR ÉLASTIQUE DANS LA FABRICATION DE PIÈCES FORMÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2020 DE 102020201738**

(43) Veröffentlichungstag der Anmeldung:
**18.08.2021 Patentblatt 2021/33**

(73) Patentinhaber:
• **inigence gmbh**
  **74626 Bretzfeld (DE)**
• **Hochschule Heilbronn**
  **74081 Heilbronn (DE)**

(72) Erfinder:
• **Birkert, Arndt**
  **74626 Bretzfeld (DE)**
• **Hartmann, Benjamin**
  **97950 Großrinderfeld (DE)**
• **Straub, Markus**
  **74182 Obersulm (DE)**

(74) Vertreter: **Patentanwälte**
**Ruff, Wilhelm, Beier, Dauster & Partner mbB**
**Kronenstraße 30**
**70174 Stuttgart (DE)**

(56) Entgegenhaltungen:
**DE-A1- 102005 044 197**

• **YANG XIANG AN ET AL: "A die design method for springback compensation based on displacement adjustment", INTERNATIONAL JOURNAL OF MECHANICAL SCIENCES., vol. 53, no. 5, 1 May 2011 (2011-05-01), GB, pages 399 - 406, XP055784506, ISSN: 0020-7403, DOI: 10.1016/j.ijmecsci.2011.03.002**
• **GIANFRANCO RUGGIERO ET AL: "The Challenge of Compensation: The Use of the Draw-Shell Method", FORMINGWORLD, 11 October 2017 (2017-10-11), pages 1 - 5, XP055718006, Retrieved from the Internet <URL:https://formingworld.com/draw-shell-method-compensation/> [retrieved on 20200724]**

**Beschreibung**

ANWENDUNGSGEBIET UND STAND DER TECHNIK

Die Erfindung befasst sich mit der Korrektur der Rückfederung bei der Herstellung von Umformteilen. Im Speziellen betrifft die Erfindung ein computergestütztes Verfahren zur Herstellung eines Umformwerkzeugs mit einer rückfederungs-skalierten Wirkfläche zur Herstellung eines komplexen Umformteils durch ziehtechnisches Umformen.

Die Herstellung von Umformteilen aus Blech, insbesondere Karosserieteilen für Fahrzeuge, erfolgt üblicherweise mittels mehrstufiger Formprozesse, die eine Abfolge mehrerer aufeinanderfolgender Formoperationen aufweisen. Hierbei wird üblicherweise ein Halbzeug in Form einer Blechplatine zunächst mittels eines Umformverfahrens, zum Beispiel durch Tiefziehen, beispielsweise Karosserieziehen oder Formprägen, umgeformt und hiernach in weiteren Formoperationen weiterbearbeitet. Diese weiteren Formoperationen können beispielsweise eine weitere ziehtechnische Bearbeitung, ein Beschneiden, ein Nachschlagen, ein Einstellen, ein Nachformen oder dergleichen vorsehen.

Die Herstellung eines Umformwerkzeugs verläuft typischerweise in zahlreichen Stufen. Eine umfassende Darstellung findet sich in dem Fachbuch: A. Birkeit, S. Haage, M. Straub: "Umformtechnische Herstellung komplexer Karosserieteile - Auslegung von Ziehanlagen", Springer Vieweg-Verlag (2013), Kapitel 5.9. Dabei wird bis zur Stufe der sogenannten Werkzeugeinarbeitung und Werkzeugausprobe zunächst ein grundsätzlich funktionsfähiges Umformwerkzeug hergestellt. Daran schließt sich die Stufe der Werkzeugkorrektur an. Diese beinhaltet solche Maßnahmen, die am grundsätzlich funktionsfähigen Umformwerkzeug vorgenommen werden, um neben einer reißerfreien und faltenfreien Herstellbarkeit auch eine anforderungsgerechte Maß- und Formhaltigkeit des herzustellenden Umformteils zu gewährleisten. Die Werkzeugkorrektur erfolgt üblicherweise - aber nicht unbedingt ausschließlich - simulationsgestützt, beispielsweise auf Grundlage einer Finite-Elemente-Methode.

Die im Rahmen der Werkzeugkorrektur vorzunehmenden Maßnahmen sind erforderlich, da sich komplexe Umformteile in der Praxis bei Werkzeugnullgeometrie nicht auf Anhieb innerhalb vorgegebener Maß- und Formtoleranzen fertigen lassen. Dabei haben Toleranzabweichungen am ersten werkzeugfallenden Umformteil mannigfaltige Ursachen, sowohl in Bezug auf einen Absolutwert der Abweichung als auch auf die Streuung der Abweichung über mehrere Umformteile hinweg. Die genannten Toleranzabweichungen sind überwiegend die Folge einer elastischen Rückfederung des Umformteils nach dem Öffnen des Umformwerkzeugs und/oder nach der Entnahme des Umformteils aus demselben. Dabei ist allgemein bekannt, dass die elastische Rückfederung des Umformteils erhebliche Kosten im Rahmen der Werkzeugherstellung verursacht. Nicht unerhebliche Anteile der Gesamtkosten der Werkzeugherstellung müssen aufgewendet werden, um das grundsätzlich funktionsfähige Umformwerkzeug im Rahmen der Werkzeugkorrektur anzupassen.

Die elastische Rückfederung des Umformteils äußert sich zum einen in Maß- und Formabweichungen gegenüber der Werkzeugnullgeometrie infolge von beispielsweise Aufbiegungen, Verdrehungen, Verdrillungen oder dergleichen des Umformteils. Zum anderen bewirkt die elastische Rückfederung eine Verkleinerung der Oberfläche des Umformteils, was auch als Schrumpfen oder Schrumpfung bezeichnet werden kann. Letzteres kann dazu führen, dass die vorgegebenen Maß- und Formtoleranzen nicht erreicht werden. Zudem kann es bei mehrstufigen Umformprozessen dazu kommen, dass das geschrumpfte Umformteil nicht anforderungsgerecht mit den Werkzeugen nachfolgender Umformoperationen zusammenwirkt.

Maßnahmen zur werkzeugseitigen Korrektur der genannten Aufbiegungen, Verdrehungen, Verdrillungen oder dergleichen des Umformteils werden auch als Werkzeugkompensation oder kurz Kompensation bezeichnet.

Maßnahmen zur werkzeugseitigen Korrektur der elastischen Schrumpfung des Umformteils werden auch als Werkzeugskalierung oder kurz Skalierung bezeichnet.

Sowohl zur Kompensation als auch zur Skalierung der elastischen Rückfederung existieren unterschiedliche Ansätze im Stand der Technik. Diese zielen - ausgehend von einem grundsätzlich funktionsfähigen Umformwerkzeug - darauf ab, Maß- und Formabweichungen des Umformteils nach der betreffenden Formoperation mittels einer Anpassung der das Umformteil der betreffenden Formoperation abbildenden Wirkfläche des Umformwerkzeugs zu beseitigen, so dass am Ende eines ein- oder mehrstufigen Formprozesses eine toleranzgerechte Zielgeometrie des Umformteils erreicht wird. Die Zielgeometrie wird im Rahmen dieser Anmeldung auch als "Nullgeometrie" des Werkstücks bezeichnet. Insbesondere folgende Definitionen sollen im Rahmen dieser Anmeldung gelten:

Unter "Nullgeometrie" oder "Werkstücknullgeometrie" soll diejenige Geometrie des Umformteils verstanden werden, die in der betreffenden Formoperation des ein- oder mehrstufigen Formprozesses erreicht werden soll. Das Umformteil kann auch als Werkstück bezeichnet werden.

Ein Umformwerkzeug, das entsprechend einer CAD-Sollgeometrie des herzustellenden Umformteils - das heißt der Nullgeometrie - modelliert ist, wird auch als "Nullwerkzeug" bezeichnet. In einem solchen - weder kompensierten noch skalierten - Umformwerkzeug sind die Werkzeugnullgeometrie und die Werkstücknullgeometrie identisch. Das Umformwerkzeug kann auch als Werkzeug bezeichnet werden.

Unter "Wirkfläche" oder "Wirkflächengeometrie" des Umformwerkzeugs sind diejenigen Abschnitte der Oberfläche des Umformwerkzeugs zu verstehen, die zum Zwecke der Umformung auf das Umformteil einwirken. Dabei soll "skalierte Wirkfläche" die zum Ausgleich der Schrumpfung der Oberfläche des Umformteils korrigierte Wirkfläche bezeichnen. Weiter soll "kompensierte Wirkfläche" die zum Ausgleich der Aufbiegung, Verdrehung, Verdrillung oder dergleichen des Umformteils korrigierte Wirkfläche bezeichnen. Die skalierte und/oder kompensierte Wirkfläche weicht zwingend von der in der betreffenden Formoperation zu erreichenden Nullgeometrie ab, da nach dem Öffnen des Werkzeugs und/oder der Entnahme des Werkstücks aus demselben eine elastische Rückfederung des Werkstücks zu verzeichnen ist.

Mit "Rückfederungsgeometrie" wird die nach dem Öffnen des Werkzeugs und/oder nach der Entnahme des Werkstücks aus demselben sich ergebende Werkstückgeometrie bezeichnet. Die Rückfederungsgeometrie kann auch als elastisch rückgefederte Geometrie bezeichnet werden. Die Rückfederungsgeometrie des Werkstücks soll jedenfalls nach der letzten Formoperation des ein- oder mehrstufigen Formprozesses der angestrebten Nullgeometrie entsprechen. Vereinfacht ausgedrückt soll eine Korrekturstrategie so beschaffen sein, dass durch eine Ermittlung entsprechend rückfederungs-korrigierter, das heißt skalierter und kompensierter, Wirkgeometrien des Umformwerkzeugs die Herstellung eines Umformteils in Nullgeometrie ermöglicht wird. Dabei kann ein Umformwerkzeug, dessen Wirkgeometrie entsprechend skaliert und kompensiert ist, auch als "korrigiertes Werkzeug" bezeichnet werden.

Bei der Blechumformung werden üblicherweise Werkstücke betrachtet, deren Geometrie sich in der Regel dadurch auszeichnet, dass die Ausdehnung in Dickenrichtung wesentlich geringer ausfällt als die Ausdehnung in die verbleibenden beiden Richtungen. Dies erlaubt es, aus einem Volumenmodell des Werkstücks geeignet eine Mittelfläche abzuleiten und die Geometrie des Werkstücks über diese Mittelfläche zu parametrisieren. Einem Mittelflächenpunkt kann ein lokales Koordinatensystem zugeordnet werden, dessen $x_1$- und $x_2$-Achse in der Tangentialebene an die Mittelfläche liegen und dessen $x_3$-Achse in Dickenrichtung zeigt. Über die Parametrisierung des Werkstücks kann jedem Materialpunkt im Werkstück ein Punkt auf der Mittelfläche zugeordnet werden und somit auch das diesem Mittelflächenpunkt zugehörige lokale Koordinatensystem. In jedem Materialpunkt des Werkstücks wird der Spannungstensor $\sigma = (\sigma_{ij})$, $i,j = 1,2,3$ bzgl. des lokalen Koordinatensystems als lokaler Spannungstensor bezeichnet, die Komponenten $\sigma_{ij}$ als lokale Spannungen.

Vorzugsweise werden die lokalen Spannungen über die Dickenrichtung geeignet gemittelt, um Biegespannungen zu eliminieren, die durch einen nichtkonstanten Spannungsverlauf in Dickenrichtung entstehen würden. In diesem Zusammenhang wird von gemittelten lokalen Spannungen gesprochen.

Die lokalen, vorzugsweise gemittelten, Spannungen in der Membranebene, die im lokalen Koordinatensystem $(x_1,x_2,x_3)$ den Tensorkomponenten $\sigma_{11}$, $\sigma_{22}$, $\sigma_{12}$ und $\sigma_{21}$ entsprechen, können auch als Membranspannungen bezeichnet werden. Jedem Materialpunkt im Werkstück können somit Membranspannungen zugewiesen werden.

Die obigen Bezeichnungen sind für ein Kontinuum gültig und somit zunächst unabhängig von einer konkreten Diskretisierungsmethode. Im Zuge der Diskretisierung werden Spannungen in der Regel in diskreten Knoten ausgewertet und/oder vorgegeben, die im Folgenden als Kollokationspunkte bezeichnet werden, z.B. Elementknoten oder Integrationspunkte bei der Finite-Elemente-Methode. Grundsätzlich können jedem Kollokationspunkt ein lokaler Spannungstensor und somit (lokale) Membranspannungen zugewiesen werden.

Im Stand der Technik sind unterschiedliche Skalierungsansätze für Umformwerkzeuge bekannt.

Ein bekannter Ansatz wird in oben genanntem Fachbuch in Kapitel 8.6.1 beschrieben und als globaler Skalierungsansatz bezeichnet. Dieser globale Skalierungsansatz sieht vor, dass die Wirkflächengeometrie auf Grundlage eines einheitlichen Skalierungsfaktors angepasst wird, der auf werkstoffspezifischen Kennwerten des Umformteils basiert:

$$F_{scale} = 1 + \frac{\sigma_{biax}}{E}$$

Dabei bezeichnet E den E-Modul und $\sigma_{biax}$ die zweiachsige Fließspannung. Dieser Ansatz wird beispielsweise in der kommerziellen Simulationssoftware "AutoForm®" der AutoForm Engineering GmbH, Neerach (CH) verwendet und in dem zugrunde liegenden Manual erläutert.

Im Stand der Technik sind zudem unterschiedliche Kompensationsansätze für Umformwerkzeuge bekannt. Zu nennen sind insbesondere die Comprehensive Compensation (CC) Methode ebenso wie die Spring Forward (SF) Methode. Hierzu wird zum Beispiel auf R. A. Lingbeek et al.: "Theoretical verification of the displacement adjustment and spring forward algorithms for springback compensation", Int J Mater Form (2008) 1:159-168 *sowie* Yang Xiang An et al.: "A die design method for springback compensation based on displacement adjustment", International Journal of Mechanical Sciences, Bd. 53, Nr. 5., 1. Mai 2011 (2011-05-01), Seiten 399-406 verwiesen. Zudem ist aus der deutschen Offenlegungsschrift DE 10 2016 212 933 A1 ein als Physical-Compensation-Methode bekannter simulationsgestützter Kompensationsansatz bekannt.

## AUFGABE UND LÖSUNG

Vor diesem Hintergrund liegt der Erfindung die Aufgabe zugrunde, ein Verfahren der eingangs genannten Art bereitzustellen, das eine möglichst allgemeingültige Anwendbarkeit auf unterschiedliche ein- oder mehrstufige Formprozesse bei verbesserten Ergebnissen ermöglicht und gleichzeitig Vorteile im Hinblick auf eine sich an die Rückfederungsskalierung anschließende Rückfederungskompensation des Umformwerkzeugs bietet.

Zur Lösung dieser Aufgabe stellt die Erfindung ein Verfahren mit den Merkmalen von Anspruch 1 sowie ein Computerprogrammprodukt mit den Merkmalen von Anspruch 11 bereit. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Eine mit dem herkömmlichen globalen Skalierungsansatz verbundene Problematik besteht darin, dass allenfalls eine grobe Näherung der tatsächlichen physikalischen Gegebenheiten am Werkstück erreicht wird. Dies, da unter der vereinfachten Annahme eines über das gesamte Werkstück einheitlichen Zug-Zug-Spannungszustands lediglich ein global einheitlicher Skalierungsfaktor ermittelt wird. Die Folgen eines solchen globalen Skalierungsansatzes können insbesondere unerwünschte lokale Deformationen und/oder Druckstellen sowie Maßabweichungen sein. Die besagten Deformationen und/oder Druckstellen können sich zudem nachteilig auf eine sich an die Rückfederungsskalierung anschließende Rückfederungskompensation auswirken. Sofern ein simulationsgestützter Kompensationsansatz verfolgt wird, kann beispielsweise dessen Konvergenzverlauf beeinträchtigt werden. Zudem können aufwendige Nacharbeiten bei der physischen Werkzeugeinarbeitung notwendig werden.

Diese Probleme können bei Nutzung von Verfahren und/oder Systemen gemäß der beanspruchten Erfindung vermindert oder vermieden werden.

Das erfindungsgemäße Verfahren mit den Merkmalen von Anspruch 1 umfasst die Schritte a) bis d) sowie den Schritt f). Dementsprechend basiert die erfindungsgemäße Lösung nicht lediglich auf einer einfachen, globalen Näherung des werkstückseitig vorherrschenden Spannungszustands. Stattdessen werden lokal vorherrschende Spannungen berücksichtigt und zur Grundlage der Ermittlung einer lokal angepassten, örtlich unterschiedlichen Skalierung gemacht. Hierdurch kann im Ergebnis eine qualitativ verbesserte Rückfederungsskalierung der Wirkflächengeometrie des Umformwerkzeugs erreicht werden. Dies kann sich insbesondere vorteilhaft auf eine sich möglicherweise anschließende Rückfederungskompensation der Wirkflächengeometrie auswirken. Denn lokale Druckstellen und/oder Deformationen, wie sie aus einer global genäherten Skalierung resultieren können, werden durch den erfindungsgemäß lokal "exakten" Skalierungsansatz vermindert oder vermieden.

Der Schritt a) sieht ein Simulieren wenigstens einer elastisch-plastischen Umformoperation, die auch als Formänderungsoperation bezeichnet werden kann, mittels einer Diskretisierungsmethode vor, wobei ein diskretisiertes Werkstück mittels einer Einwirkung wenigstens eines Werkzeugs umgeformt wird. Vorzugsweise erfolgt das Simulieren mittels einer Finite-Elemente-Methode und damit auf Grundlage eines finite-elemente-diskretisierten Werkstücks. Das Werkstück repräsentiert das Umformteil und ist insoweit ein virtuelles Werkstück. Das zur Einwirkung auf das Werkstück vorgesehene wenigstens eine Werkzeug repräsentiert das Umformwerkzeug und ist insoweit ein virtuelles Werkzeug. Zur formändernden Einwirkung auf das Werkstück weist das wenigstens eine Werkzeug eine Wirkflächengeometrie auf. Die Wirkflächengeometrie des wenigstens einen Werkzeugs repräsentiert die Nullgeometrie der Wirkfläche des Umformwerkzeugs. Mit anderen Worten ausgedrückt, wird in Schritt a) ein Nullwerkzeug verwendet. Das Werkstück wird in eine erste Konfiguration elastisch-plastisch umgeformt. Dabei wird die Einwirkung des Werkzeugs in der ersten Konfiguration beibehalten, so dass eine elastische Rückfederung des Werkstücks unterbunden wird. Vorzugsweise wird das Werkstück in der ersten Konfiguration beschnitten, was jedoch nicht zwingend der Fall sein muss.

Der Schritt b) sieht ein Ermitteln von in der ersten Konfiguration vorliegenden lokalen Spannungen des Werkstücks vor. Es wird auf die im Rahmen dieser Anmeldung geltende und eingangs erläuterte Definition der lokalen Spannungen verwiesen. Der Spannungszustand liegt auf diskreter Ebene üblicherweise an den Kollokationspunkten der verwendeten Diskretisierungsmethode an. Sofern eine Finite-Elemente-Methode zugrunde gelegt ist, liegt der Spannungszustand auf diskreter Ebene an Integrationsstellen oder Elementknoten des jeweiligen Elementes an, welche insoweit die besagten Kollokationspunkte bilden. Der Spannungszustand wird durch einen zweistufigen Spannungstensor repräsentiert, der simulationsseitig in einer grundsätzlich bekannten Matrizenschreibweise vorliegen und/oder gespeichert sein kann. Zudem hat es sich als vorteilhaft erwiesen, wenn die ermittelten lokalen Spannungen geeignet über die Dicke gemittelt werden, so dass die lokalen Spannungsverläufe in Dickenrichtung jeweils konstant sind. Bei unregelmäßigen Diskretisierungen, insbesondere Finite-Elemente-Netzen, können Interpolationsverfahren nötig sein, um gegebenenfalls weitere Spannungswerte entlang der Dickenrichtung zu ermitteln. Grundsätzlich werden durch eine solche Mittelung Biegespannungen unterdrückt, die durch einen nichtkonstanten Spannungsverlauf in Dickenrichtung entstehen. Eine solche Mittelung ist jedoch nicht zwingend.

Der Schritt c) sieht ein Anpassen der ermittelten lokalen Spannungen nach Vorzeichen und/oder Betrag vor. Das Anpassen erfolgt auf diskreter Ebene. Sofern eine Mittelung der lokalen Spannungen vorgesehen ist, werden die gemittelten lokalen Spannungen angepasst. Bei dem Anpassen werden die Vorzeichen der jeweiligen Membranspannungskomponenten des lokalen Spannungstensors in den gegebenen Kollokationspunkten umgekehrt und die Beträge der jeweiligen übrigen Spannungskomponenten werden verringert. Der Schritt c) geht von der Überlegung aus, dass nicht sämtliche Spannungskomponenten des lokalen Spannungstensors maßgeblich für die zu korrigierende elastische Schrumpfung des Werkstücks sind. Vielmehr sind in erster Linie die vorherrschenden Membranspannungskomponenten maßgeblich. Diese sind gemäß des eingangs definierten lokalen Koordinatensystems als $\sigma_{11}$, $\sigma_{22}$, $\sigma_{12}$ und $\sigma_{21}$ gegeben. Die übrigen Spannungskomponenten sind diesbezüglich weniger oder nicht relevant. Die Vorzeichen der Membranspannungskomponenten werden jeweils umgekehrt, so dass eine in der ersten Konfiguration ursprünglich als Druckspannung mit negativem Vorzeichen vorliegende Membranspannungskomponente in eine Zugspannung mit positivem Vorzeichen angepasst wird und umgekehrt. Diese Vorzeichenumkehr kann auch als Negieren bezeichnet werden. Der jeweilige Betrag der Membranspannungskomponenten bleibt vorzugsweise unverändert. Demgegenüber werden die übrigen Spannungskomponenten dem Betrag nach verringert. Beispielsweise können die übrigen Spannungskomponenten auf einen vorbestimmten Betrag reduziert oder mittels eines vorbestimmten Faktors $0 < f < 1$ multipliziert werden. Die Vorzeichen der übrigen Spannungskomponenten verbleiben vorzugsweise unverändert. Diese Anpassung der lokalen Spannungen wird vorzugsweise für das gesamte diskretisierte Werkstück durchgeführt.

Der Schritt d) sieht ein Simulieren einer elastischen Deformation des Werkstücks ausgehend von der ersten Konfiguration und ausgehend von den gemäß Schritt c) angepassten lokalen Spannungen vor. Mit anderen Worten ausgedrückt erfolgt die Simulation im Schritt d) ausgehend von einem virtuell geschlossenen Werkzeug in einen virtuell geöffneten Zustand des Werkzeugs. Infolge der Öffnung des Werkzeugs wird das Werkstück in eine von externer Krafteinwirkung wenigstens weitgehend, vorzugsweise vollständig, freie zweite Konfiguration deformiert. In der zweiten Konfiguration liegt das Werkstück in einer elastisch deformierten Deformationsgeometrie vor. Vereinfacht ausgedrückt erfährt das Werkstück infolge der gemäß Schritt c) angepassten lokalen Spannungen anstelle einer elastischen Schrumpfung eine elastische, flächenhafte Ausdehnung. Diese Ausdehnung ist aufgrund der unterschiedlichen Spannungsanpassung in den Kollokationspunkten der Diskretisierung in Schritt c) nach Betrag und Richtung örtlich unterschiedlich.

Der Schritt f) sieht ein Erzeugen einer skalierten Wirkflächengeometrie des Werkzeugs in Abhängigkeit der ermittelten Deformationsgeometrie des Werkstücks vor. Dementsprechend wird die in Schritt a) zunächst als Nullgeometrie vorliegende Wirkfläche des Werkzeugs unter Verwendung der Simulationsergebnisse des Schritts d) angepasst. Vereinfacht ausgedrückt wird die Deformationsgeometrie des Werkstücks auf die Wirkflächengeometrie des Werkzeugs abgebildet oder gemapped, so dass die skalierte Wirkflächengeometrie wenigstens im Wesentlichen, vorzugsweise vollständig, der Deformationsgeometrie des Werkstücks entspricht. Im Unterschied zu üblichen globalen Skalierungsansätzen erfolgt die Skalierung der Wirkflächengeometrie zur Korrektur der elastischen Werkstückschrumpfung nicht einheitlich global über die gesamte Wirkflächengeometrie hinweg, sondern lokal unterschiedlich und angepasst auf die lokale Schrumpfung des Werkstücks.

In weiterer Ausgestaltung des Verfahrens umfasst der Schritt c) ein Verringern der Beträge der übrigen Spannungskomponenten mittels Multiplikation mit einem Faktor $< 10^{-1}$, bevorzugt $< 10^{-4}$, besonders bevorzugt $< 10^{-16}$. Mit anderen Worten ausgedrückt werden die Beträge der übrigen Spannungskomponenten deutlich verringert und je nach Wahl des Faktors quasi zu Null gesetzt. Letzteres kann auch als "Eliminieren" bezeichnet werden. Anstelle einer Multiplikation kann alternativ ein vorbestimmter Zahlenwert zugrunde gelegt werden, auf welchen die Beträge der übrigen Spannungskomponenten verringert werden.

In weiterer Ausgestaltung der Erfindung umfasst das Verfahren den Schritt e), der ein Korrigieren der angepassten lokalen Spannungen in Abhängigkeit eines Vergleichs zwischen der ermittelten Deformationsgeometrie und einer Rückfederungsgeometrie des Werkstücks vorsieht. Die Rückfederungsgeometrie bezeichnet die nach dem virtuellen Öffnen des Werkzeugs sich ergebende elastisch rückgefederte Werkstückgeometrie, die ausgehend von der ersten Konfiguration und ausgehend von den ermittelten - nicht angepassten - lokalen Spannungen eingenommen wird. Durch das Korrigieren der angepassten lokalen Spannungen kann eine nochmals verbesserte Qualität der skalierten Wirkflächengeometrie erreicht werden. Dabei umfasst das Korrigieren ein weiteres Anpassen der gemäß Schritt c) nach Vorzeichen angepassten Membranspannungskomponenten, wobei vorzugsweise lediglich deren Betrag korrigiert bzw. weiter angepasst wird. Das Vorzeichen der angepassten Membranspannungskomponenten bleibt bei der Korrektur gemäß Schritt e) vorzugsweise unverändert. Vorzugsweise verbleiben die übrigen Spannungskomponenten ausgehend von der Anpassung gemäß Schritt c) im Schritt e) unverändert. Die Korrektur der angepassten Membranspannungskomponenten erfolgt derart, dass eine betragsmäßig wenigstens im Wesentlichen, vorzugsweise vollständig, übereinstimmende lokale Dehnung der Deformationsgeometrie und der Rückfederungsgeometrie jeweils in Bezug auf die Nullgeometrie erreicht wird. Wobei im Falle einer negativen Dehnung der Rückfederungsgeometrie, eine positive Dehnung der Deformationsgeometrie erreicht werden soll und umgekehrt.

In weiterer Ausgestaltung der Erfindung umfasst das Korrigieren der angepassten lokalen Spannungen gemäß Schritt e) die Schritte e1) bis e6).

Der Schritt e1) sieht ein Simulieren einer elastischen Rückfederung des Werkstücks ausgehend von der ersten Konfiguration und ausgehend von den ermittelten, nicht angepassten lokalen Spannungen vor. Dementsprechend erfolgt die Simulation in dem Schritt e1) wiederum ausgehend von einem virtuell geschlossenen Zustand des Werkzeugs. Als lokale Spannungen werden die in der ersten Konfiguration ermittelten und somit tatsächlich vorliegenden Spannungen zugrunde gelegt. Ausgehend von der ersten Konfiguration erfolgt die elastische Rückfederung des Werkstücks bei einem simulierten, virtuellen Öffnen des Werkzeugs in eine dritte Konfiguration. In der dritten Konfiguration ist das Werkstück wenigstens weitgehend, vorzugsweise vollständig, frei von externer Krafteinwirkung. In der dritten Konfiguration liegt das Werkstück in einem elastisch rückgefederten Zustand vor und nimmt somit die Rückfederungsgeometrie ein.

Der Schritt e2) sieht ein Ermitteln wenigstens einer ersten Abweichungsgröße zwischen der Nullgeometrie und der Rückfederungsgeometrie vor. Die erste Abweichungsgröße kann beispielsweise eine skalare oder vektorielle geometrische Größe sein, die den geometrischen Unterschied zwischen der Nullgeometrie und der elastisch rückgefederten Rückfederungsgeometrie des Werkstücks beschreibt. Das Ermitteln erfolgt in Kollokationspunkten der zugrunde gelegten Diskretisierung. Sofern eine Finite-Elemente-Diskretisierung zugrunde gelegt ist, erfolgt das Ermitteln elementweise und somit vorzugsweise an jedem Integrationspunkt und/oder an jedem Elementknoten der zugrunde liegenden Finite-Elemente-Diskretisierung des Werkstücks.

Der Schritt e3) sieht ein Ermitteln wenigstens einer zweiten Abweichungsgröße zwischen der Nullgeometrie und der Deformationsgeometrie vor. Die zweite Abweichungsgröße kann beispielsweise eine skalare oder vektorielle Größe sein, welche die geometrischen Abweichungen zwischen der auf Grundlage der gemäß Schritt c) angepassten lokalen Spannungen ermittelten Deformationsgeometrie und der Nullgeometrie des Werkstücks beschreibt. Die zweite Abweichungsgröße wird vorzugsweise in den Kollokationspunkten der zugrunde gelegten Diskretisierung ermittelt. Sofern eine Finite-Elemente-Diskretisierung zugrunde gelegt ist, erfolgt das Ermitteln elementweise und somit vorzugsweise an jedem Integrationspunkt und/oder an jedem Elementknoten der zugrunde liegenden Finite-Elemente-Diskretisierung des Werkstücks.

Der Schritt e4) sieht ein Ermitteln wenigstens eines Korrekturfaktors in Abhängigkeit der ersten Abweichungsgröße und der zweiten Abweichungsgröße vor. Der Korrekturfaktor kann beispielsweise ein aus den Abweichungsgrößen gebildeter Quotient, eine Differenz oder dergleichen sein. Der Korrekturfaktor wird vorzugsweise in den Kollokationspunkten der zugrunde gelegten Diskretisierung ermittelt. Sofern eine Finite-Elemente-Diskretisierung zugrunde gelegt ist, erfolgt das Ermitteln elementweise und somit vorzugsweise an jedem Integrationspunkt und/oder an jedem Elementknoten der zugrunde liegenden Finite-Elemente-Diskretisierung des Werkstücks. Der Schritt e5) sieht ein Korrigieren der angepassten lokalen Spannungen in der ersten Konfiguration vor. Hierbei werden die gemäß Schritt c) angepassten, in ihren Vorzeichen umgekehrten Membranspannungskomponenten mit dem jeweils ermittelten Korrekturfaktor multipliziert. Die übrigen Spannungskomponenten verbleiben im Schritt e5) vorzugsweise unverändert. Die Korrektur erfolgt vorzugsweise in den Kollokationspunkten der zugrunde gelegten Diskretisierung. Sofern eine Finite-Elemente-Diskretisierung zugrunde gelegt ist, erfolgt die Korrektur elementweise und somit vorzugsweise an jedem Integrationspunkt und/oder an jedem Elementknoten der zugrunde liegenden Finite-Elemente-Diskretisierung des Werkstücks.

Der Schritt e6) sieht ein erneutes Simulieren der elastischen Deformation gemäß Schritt d) und ausgehend von den gemäß Schritt e5) korrigierten lokalen Spannungen vor. Durch das vorherige Korrigieren der angepassten lokalen Spannungen kann eine betragsmäßige Angleichung der sich in der Rückfederungs- und Deformationsgeometrie einstellenden geometrischen Abweichungen gegenüber der Nullgeometrie erreicht werden.

Das Korrigieren der angepassten lokalen Spannungen gemäß Schritt e) und gegebenenfalls gemäß der Schritte e1) bis e6) erfolgt vorzugsweise zwischen dem Simulieren der elastischen Deformation gemäß Schritt d) und dem Erzeugen der skalierten Wirkflächengeometrie gemäß Schritt f).

In weiterer Ausgestaltung des Verfahrens werden die Schritte e3) bis e6) iterativ durchlaufen. Die Iteration erfolgt bis zum Erreichen eines in Abhängigkeit des Korrekturfaktors gebildeten Konvergenzkriteriums. Alternativ oder zusätzlich erfolgt die Iteration bis zum Erreichen einer maximalen Anzahl an Iterationen. Bei dieser Ausgestaltung der Erfindung erfolgt somit eine iterative Angleichung der geometrischen Abweichungen zwischen der Deformations- und der Nullgeometrie an die Abweichungen zwischen der Rückfederungs- und der Nullgeometrie. Diese Angleichung erfolgt im Hinblick auf die Beträge der Abweichungen.

In weiterer Ausgestaltung der Erfindung wird die Iteration dann beendet, wenn der Betrag des Korrekturfaktors 1,00 beträgt. Hierbei wird der Korrekturfaktor vorzugsweise als Quotient aus der ersten Abweichungsgröße und der zweiten Abweichungsgröße gebildet. Mit anderen Worten ausgedrückt wird die Iteration dann beendet, wenn die geometrischen Abweichungen zwischen der Deformations- und der Nullgeometrie betragsmäßig mit den geometrischen Abweichungen zwischen der Rückfederungs- und der Nullgeometrie übereinstimmen.

In weiterer Ausgestaltung der Erfindung umfasst das Verfahren einen Schritt g1), der ein Ermitteln einer rückfederungs-kompensierten Wirkflächengeometrie des Werkzeugs auf Grundlage der zuvor erzeugten skalierten Wirkflächengeometrie vorsieht, wobei eine Physical-Compensation-Methode verwendet wird. Diese Ausgestaltung des Verfahrens umfasst somit die werkzeugseitige Kompensation der rückfederungsbedingten Form- und Maßabweichungen des Werkstücks infolge von Verdrehungen, Verdrillungen oder dergleichen. Dabei erfolgt die Kompensation ausgehend von der zuvor skalierten Wirkflächengeometrie des Werkzeugs und somit nicht etwa ausgehend von der Nullgeometrie. Im Stand der Technik sind unterschiedlichste Kompensationsansätze bekannt, wobei jedoch nicht alle Ansätze vorteilhaft mit dem erfindungsgemäßen Verfahren und seinen Ausgestaltungen kombinierbar sind. Bei dieser Ausgestaltung der Erfindung wird zur Kompensation die als solche bekannte Physical-Compensation-Methode genutzt, die beispielsweise in der deutschen Offenlegungsschrift DE 10 2016 212 933 A1 im Detail beschrieben ist. Es hat sich gezeigt, dass die Kombination der erfindungsgemäßen Skalierung mit der Physical-Compensation-Methode gute Ergebnisse liefert. Denn zum einen kann das Konvergenzverhalten der Physical-Compensation-Methode durch eine vorherige Skalierung der Wirkflächengeometrie gemäß dem erfindungsgemäßen Verfahren verbessert werden. Zum anderen ermöglicht die Physical-Compensation-Methode eine sogenannte "flächengleiche" Kompensation der Wirkflächengeometrie, so dass die vorherige Skalierung der Wirkflächengeometrie nicht durch die Kompensation beeinflusst wird. Dies ist eine besonders vorteilhafte Ausgestaltung der Erfindung.

In weiterer Ausgestaltung der Erfindung umfasst das Verfahren einen Schritt g2), der ein Ermitteln einer rückfederungs-kompensierten Wirkflächengeometrie des Werkzeugs auf Grundlage der zuvor erzeugten skalierten Wirkflächengeometrie vorsieht, wobei eine Displacement-Adjustment-Methode und/oder eine Comprehensive-Compensation-Methode verwendet wird. Die Displacement-Adjustment-Methode wird kurz auch als DA-Methode bezeichnet und ist als solche grundsätzlich bekannt. Die Comprehensive-Compensation-Methode wird kurz auch als C-C-Methode bezeichnet und ist ebenfalls als solche grundsätzlich bekannt. Beide vorgenannten Kompensationsansätze sind grundsätzlich zur Kompensation mit dem erfindungsgemäßen Skalierungsansatz und dessen Ausgestaltungen geeignet.

In weiterer Ausgestaltung der Erfindung wird zunächst eine Wirkflächengeometrie-Spezifikation für die Wirkfläche des Umformwerkzeugs in Abhängigkeit der erzeugten skalierten Wirkflächengeometrie des Werkzeugs ermittelt. Hiernach wird das Umformwerkzeug mittels Erzeugens der Wirkflächengeometrie gemäß der ermittelten Wirkflächengeometrie-Spezifikation hergestellt.

In weiterer Ausgestaltung der Erfindung wird das Umformteil durch ziehtechnisches Umformen unter Verwendung des hergestellten Umformwerkzeugs hergestellt.

Die Fähigkeit zur Ausführung der erfindungsgemäßen Verfahren und deren Ausgestaltungen kann in Form zusätzlicher Programmteile, Programmmodule und/oder in Form einer Programmänderung einer bestehenden Simulationssoftware implementiert werden. Daher betrifft ein weiterer Aspekt der vorliegenden Erfindung ein Computerprogrammprodukt, das insbesondere auf einem computerlesbaren Medium gespeichert oder als Signal verwirklicht ist, wobei das Computerprogrammprodukt - wenn es in einen Speicher eines geeigneten Computers geladen und von dem Computer ausgeführt ist - bewirkt, dass der Computer ein Verfahren gemäß der Erfindung und/oder einer Ausgestaltung der Erfindung ausführt.

KURZBESCHREIBUNG DER ZEICHNUNGEN

Weitere Vorteile und Merkmale der Erfindung ergeben sich aus den Ansprüchen sowie aus der nachfolgenden Beschreibung bevorzugter Ausführungsbeispiele der Erfindung, die anhand der Zeichnungen dargestellt sind.

Fig. 1     zeigt eine schematische Flussdiagrammdarstellung einer Ausführungsform eines erfindungsgemäßen Verfahrens zur Ermittlung einer rückfederungs-skalierten Wirkfläche eines Umformwerkzeugs zur Herstellung eines komplexen Umformteils durch ziehtechnisches Umformen,

Fig. 2     in einer schematischen Flussdiagrammdarstellung entsprechend Fig. 1 optionale Verfahrensschritte des Verfahrens nach Fig. 1,

Fig. 3     in schematisch stark vereinfachter Darstellung ein das Umformteil repräsentierendes Finite-Elemente-diskretisiertes Werkstück in unterschiedlichen Konfigurationen,

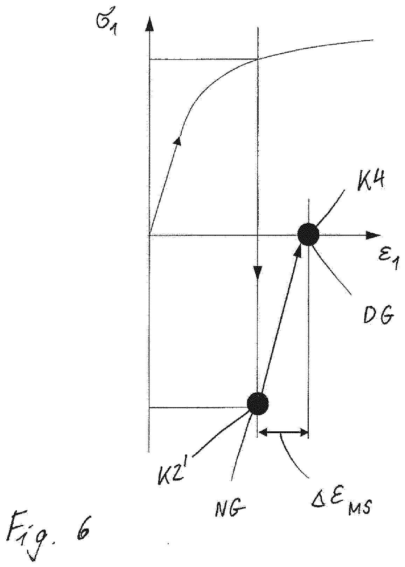

Fig. 4-8     jeweils eindimensionale Spannungs-Dehnungs-Diagramme zur weiteren Verdeutlichung des Verfahrens nach Fig. 1 und 2,

Fig. 9     in schematisch stark vereinfachter Darstellung ein exemplarisches Element der Finite-Elemente-Diskretisierung des Werkstücks in unterschiedlichen Konfigurationen,

Fig. 10,11     weitere eindimensionale Spannungs-Dehnungs-Diagramme zur ergänzenden Verdeutlichung des Verfahrens nach den Fig. 1 und 2,

Fig. 12     eine schematische Aufsicht auf eine Wirkfläche eines das (physische) Umformwerkzeug repräsentierendes (virtuelles) Werkzeug mit einem Blechhalter, einer Ankonstruktion und einem Bauteilbereich in Nullgeometrie,

Fig. 13     das Werkzeug nach Fig. 12 mit einer unter Nutzung des Verfahrens nach den Fig. 1 und 2 skalierten Wirkfläche,

Fig. 14     in schematisch stark vereinfachter Darstellung ein exemplarischer Schnitt durch das herzustellende Werkstück und das Werkezeug mit einzelnen Elementknoten, wobei unterschiedliche Konfigurationen eingenommen werden,

Fig. 15     das Werkstück und das Werkzeug in einer der Fig. 14 entsprechenden Darstellungsweise zur Verdeutlichung einer der Rückfederungs-Skalierung nachgeschalteten Rückfederungs-Kompensation und

Fig. 16     das Werkstück und das Werkzeug in einer den Fig. 14, 15 entsprechenden Darstellungsweise in unterschiedlichen Konfigurationen bei der Umformung mit skalierter als auch kompensierter Wirkflächengeometrie des Werkzeugs.

## DETAILLIERTE BESCHREIBUNG DER AUSFÜHRUNGSBEISPIELE

Im Folgenden werden einige Ausführungsbeispiele zur Erläuterung von Möglichkeiten zur praktischen Umsetzung der Erfindung erläutert. Die dargelegten erfindungsgemäßen Verfahren dienen einer computergestützten, simulationsbasierten Ermittlung einer rückfederungskorrigierten Wirkfläche eines Umformwerkzeugs, das zur Herstellung eines Umformteils mittels eines ein- oder mehrstufigen Formprozesses vorgesehen ist. Vereinfacht ausgedrückt können die erfindungsgemäßen Verfahren auch als Verfahren zur (computergestützten, simulationsbasierten) Werkzeugkorrektur bezeichnet werden. In diesem Zusammenhang ist unter einer Werkzeugkorrektur eine Anpassung der Wirkflächengeometrie eines virtuellen Werkzeugs zu verstehen, wobei die Anpassung einem Ausgleich zwangsläufig vorhandener elastischer Rückfederungen des herzustellenden Umformteils dienen soll. Diese elastischen Rückfederungen äußern sich zum einen in Maß- und Formabweichungen gegenüber einer herzustellenden Nullgeometrie infolge von beispielsweise Aufbiegungen, Verdrehungen, Verdrillungen des Umformteils. Zum anderen bewirkt die elastische Rückfederung eine Verkleinerung der Oberfläche des Umformteils, was auch als Schrumpfen bezeichnet werden kann. Maßnahmen zur werkzeugseitigen Korrektur der elastischen Schrumpfung des Umformteils werden auch als Werkzeugskalierung oder kurz Skalierung bezeichnet. Maßnahmen zur werkzeugseitigen Korrektur der genannten Aufbiegungen, Verdrehungen, Verdrillungen werden auch als Werkzeugkompensation oder kurz Kompensation bezeichnet. Die hier erläuterten Kompensationsmaßnahmen sind nicht zwingend Gegenstand der erfindungsgemäßen Verfahren. Die unter Nutzung der erfindungsgemäßen Verfahren korrigierte Wirkfläche des virtuellen Werkzeugs dient als Vorgabe zur Herstellung bzw. Spezifikation eines entsprechenden realen Umformwerkzeugs bzw. der Wirkfläche dieses Umformwerkzeugs.

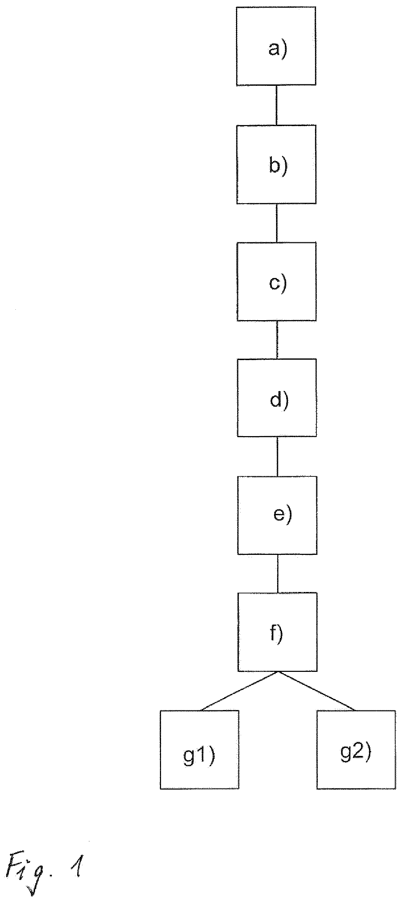

Zur Verdeutlichung einer Ausführungsform des erfindungsgemäßen Verfahrens wird zunächst auf Fig. 1 Bezug genommen. Fig. 1 zeigt eine schematische Flussdiagrammdarstellung mit Schritten a) bis f) sowie g1) und g2) des Verfahrens, wobei die Schritte e), g1) und g2) als fakultativ zu verstehen sind und insoweit nicht zwingend vorgesehen sein müssen.

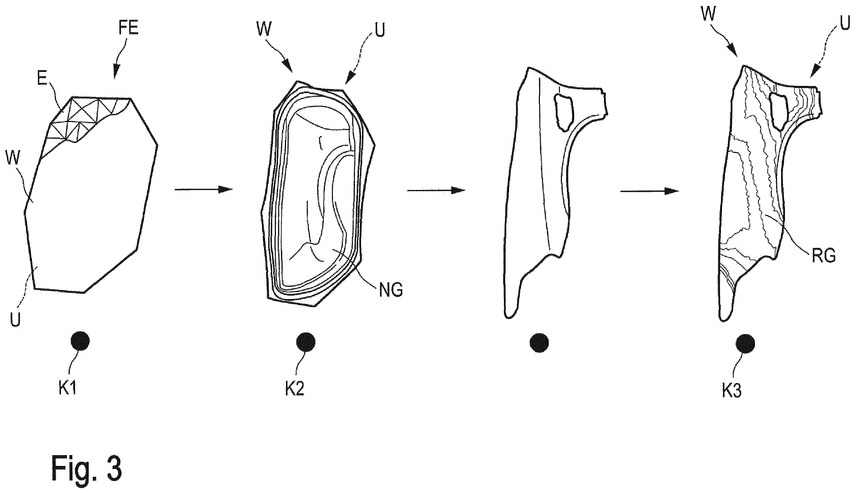

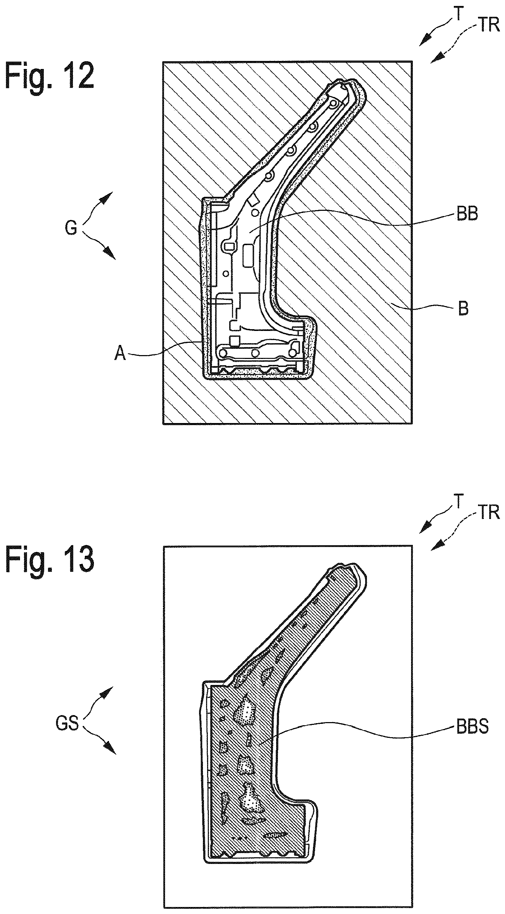

Das Verfahren sieht in Schritt a) zunächst ein Simulieren einer elastisch-plastischen Umformoperation mittels einer als solchen grundsätzlich bekannten Diskretisierungsmethode vor. Bei der gezeigten Ausführungsform ist hierfür eine Finite-Elemente-Methode vorgesehen, die als solche insbesondere im Bereich der computergestützten Simulation in der Mechanik hinlänglich bekannt ist, so dass auf diesbezügliche Details vorliegend nicht näher eingegangen wird. Die Simulation erfolgt an einem virtuellen Werkstück W, welches das herzustellende Umformteil U repräsentiert (Fig. 3). Das virtuelle Werkstück W ist mit einer in Fig. 3 schematisch angedeuteten Finite-Elemente-Diskretisierung FE versehen. Die anhand Fig. 3 ersichtliche Finite-Elemente-Diskretisierung FE ist als rein exemplarisch zu verstehen und aus einer nicht näher bestimmten, anforderungsgerecht gewählten Anzahl einzelner Elemente E gebildet. Bei dem gezeigten Ausführungsbeispiel liegt das Werkstück W in einer undeformierten Konfiguration K1 als ebene Platine vor, was jedoch nicht zwingend ist. Ausgehend von der undeformierten Konfiguration K1 wird das Werkstück W unter Einwirkung eines virtuellen Werkzeugs T in eine erste Konfiguration K2 elastisch-plastisch umgeformt. Das virtuelle Werkzeug T ist in der Fig. 12 gezeigt, wobei die dort ersichtliche Gestaltgebung als rein exemplarisch zu verstehen ist. Insoweit ist das anhand der Fig. 12 gezeigte Werkzeug T hinsichtlich seiner Gestaltgebung auch nicht zwingend zum Zusammenwirken mit dem anhand Fig. 3 gezeigten Werkstück W geeignet, was jedoch zur Verdeutlichung des Verfahrens nicht weiter erheblich ist. Das Werkzeug T weist eine zur Einwirkung auf das Werkstück W vorgesehene Wirkflächengeometrie G auf. Die Wirkflächengeometrie G repräsentiert eine Wirkfläche eines Nullwerkzeugs bzw. eine Nullgeometrie NG der Wirkfläche eines realen Umformwerkzeugs TR. Der Schritt a) sieht weiter vor, dass die Einwirkung des Werkzeugs T auf das Werkstück W in der ersten Konfiguration K2 beibehalten wird, wodurch eine elastische Rückfederung des Werkstücks W unterbunden wird.

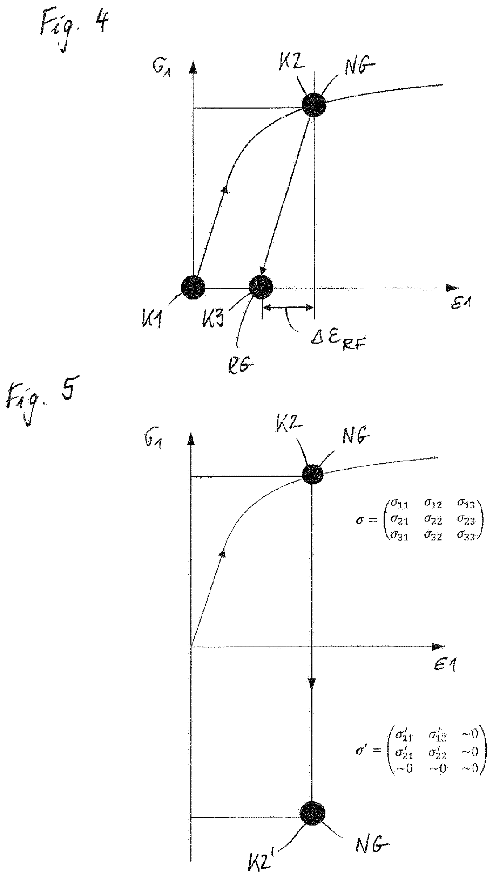

Zur weiteren Verdeutlichung wird auf Fig. 4 Bezug genommen. Dort ist ein schematisches Spannungs-Dehnungs-Diagramm mit einer rein exemplarischen, eindimensionalen Spannungs-Dehnungs-Kurve als Verlauf einer eindimensionalen elastisch-plastischen Spannung $\sigma_1$ über einer entsprechenden Dehnung $\varepsilon_1$ gezeigt. Der dort gezeigte Spannungs-Dehnungs-Verlauf zwischen der undeformierten Konfiguration K1 und der ersten Konfiguration K2 korrespondiert mit einem virtuellen Schließen des Werkzeugs T und einer damit einhergehenden elastisch-plastischen Umformung des Werkstücks W entlang der zwischen der undeformierten Konfiguration K1 und der ersten Konfiguration K2 erstreckten Spannungs-Dehnungs-Kurve. In der ersten Konfiguration K2 ist das Werkzeug T geschlossen, so dass die Geometrie des Werkstücks W und des Werkzeugs T zwangsläufig übereinstimmen. Insoweit nimmt das Werkstück W in der ersten Konfiguration K2 die Nullgeometrie NG ein.

Bei einem gedachten, virtuellen Öffnen des Werkzeugs T federt das Werkstück W entlang einer nicht näher bezeichneten Hookeschen Geraden ausgehend von der ersten Konfiguration K2 in eine dritte Konfiguration K3 (vgl. Fig. 4). In der dritten Konfiguration K3 nimmt das Werkstück W eine elastisch rückgefederte Rückfederungsgeometrie RG ein. Die Rückfederungsgeometrie RG weicht von der angestrebten Nullgeometrie NG ab, was durch die in Fig. 4 eingezeichnete Dehnung $\Delta\varepsilon_{RF}$ verdeutlicht ist. In der dritten Konfiguration K3 ist das Werkstück W gegenüber der Nullgeometrie NG vereinfacht ausgedrückt "geschrumpft", wobei $\Delta\varepsilon_{RF}$ eine Abwicklungsabweichung gegenüber der Nullgeometrie NG beschreibt. Vereinfacht ausgedrückt, soll die anhand Fig. 4 exemplarisch eingezeichnete Abweichung der Rückfederungsgeometrie RG von der Nullgeometrie NG mittels des hier beschriebenen Verfahrens werkzeugseitig korrigiert werden.

Bevor auf weitere Einzelheiten des Verfahrens nach Fig. 1 eingegangen wird, wird zunächst weiter auf Fig. 3 Bezug genommen. Dort ist ersichtlich, dass zusätzlich zu der Umformoperation zwischen den Konfigurationen K1 und K2 und vor der Konfiguration K3 eine Beschneidoperation an dem Werkstück W vorgesehen ist. Diese (virtuelle) Beschneidoperation erfolgt vorliegend nach der Simulation der elastisch-plastischen Umformung. Aufgrund der Beschneidoperation kann eine (zusätzliche) Formänderung des Werkstücks W auftreten. Zum Erreichen der ersten Konfiguration K2 ist die Beschneidoperation jedoch als rein fakultativ zu verstehen. Insoweit muss die Beschneidoperation bzw. deren Simulation nicht zwingend vorgesehen sein. Für die weitere Darstellung des Verfahrens werden die Beschneidoperation und damit einhergehende Details der Einfachheit halber vernachlässigt.

Der sich anschließende Schritt b) (vgl. Fig. 1) sieht ein Ermitteln von in der ersten Konfiguration K2 vorliegenden lokalen Spannungen $\sigma_{ij}$ des Werkstücks W vor. Die lokalen Spannungen $\sigma_{ij}$ können im Rahmen der hier verwendeten Finite-Elemente-Diskretisierung auch als Elementspannungen bezeichnet werden. Die Elementspannungen $\sigma_{ij}$ fallen bei der gezeigten Ausführungsform im Rahmen der genutzten Finite-Elemente-Methode in Schritt a) an, so dass kein gesondertes Ermitteln der Elementspannungen $\sigma_{ij}$ erforderlich ist. Die Elementspannungen $\sigma_{ij}$ werden für jedes Element E der Finite-Elemente-Diskretisierung FE ermittelt und sind anhand Fig. 5 exemplarisch in grundsätzlich bekannter Matrizenschreibweise eines lokalen, zweistufigen Spannungstensors σ verdeutlicht. Der lokale Spannungstensor σ setzt sich aus unterschiedlichen Spannungskomponenten zusammen, die in Fig. 5 in grundsätzlich bekannter Indexschreibweise bezeichnet sind. Dabei bezeichnen $\sigma_{11},\sigma_{22},\sigma_{12}$ und $\sigma_{21}$ die Membranspannungskomponenten, welche vorzugsweise vor der weiteren Verwendung in Schritt c) noch über der Dicke gemittelt werden sollen. In einer programmtechnischen Umsetzung des Verfahrens können die lokalen Spannungen bzw. Elementspannungen $\sigma_{ij}$ in bekannter Weise beispielsweise als Array und für jeden Integrationspunkt und/oder Elementknoten der Finite-Elemente-Diskretisierung des Werkstücks W gespeichert sein.

Weiter sieht der Schritt c) ein Anpassen der ermittelten Elementspannungen $\sigma_{ij}$ nach Vorzeichen und/oder Betrag vor. Hierbei werden die Vorzeichen der jeweiligen Membranspannungskomponenten $\sigma_{11},\sigma_{22}$, $\sigma_{12}$ und $\sigma_{21}$ umgekehrt. Dementsprechend wird aus einer in der ersten Konfiguration K2 vorliegenden Zugmembranspannung eine Druckmembranspannung und umgekehrt. Hinsichtlich ihres Betrags verbleiben die Membranspannungskomponenten $\sigma_{11},\sigma_{22}$, $\sigma_{12}$ und $\sigma_{21}$ in Schritt c) unverändert. Die übrigen Spannungskomponenten werden in Schritt c) ihrem jeweiligen Betrag nach verringert. Genauer sieht die vorliegende Ausführungsform vor, dass die übrigen Spannungskomponenten in Schritt c) zu Null gesetzt und hierdurch quasi "eliminiert" werden. In der programmiertechnischen Umsetzung des Verfahrens kann hierzu beispielsweise eine Multiplikation der übrigen Spannungskomponenten mit einem hinreichend kleinen Faktor $0 < f < 1$ vorgesehen sein. Vorzugsweise bewegt sich der besagte Faktor im Bereich der Maschinengenauigkeit von $10^{-16}$. Mit anderen Worten ausgedrückt werden die Elementspannungen $\sigma_{ij}$ der ersten Konfiguration K2 in Schritt c) in angepasste Elementspannungen $\sigma'_{ij}$ überführt (vgl. Fig. 5). Hierbei verbleibt das Werkzeug T in geschlossenem Zustand, so dass eine mit der Anpassung der Elementspannungen $\sigma_{ij}$ einhergehende Deformation des Werkstücks W jedenfalls zunächst durch Einwirkung des Werkzeugs T unterbunden ist. Das Werkstück W nimmt nach der Anpassung der Elementspannungen $\sigma_{ij}$ eine angepasste erste Konfiguration K2' ein, wobei aufgrund des nach wie vor geschlossenen Werkzeugs T weiterhin zwangsläufig die Nullgeometrie NG vorliegt. Dies ist anhand Fig. 5 durch den dort ersichtlichen, zwischen den Konfigurationen K2, K2' unveränderten Dehnungszustand verdeutlicht.

Der sich anschließende Schritt d) sieht ein Simulieren einer elastischen Deformation des Werkstücks W ausgehend von der (angepassten) ersten Konfiguration K2' und ausgehend von den angepassten Elementspannungen $\sigma'_{ij}$ in eine zweite Konfiguration K4 vor. In der zweiten Konfiguration K4 ist das Werkstück W frei von externer Krafteinwirkung. Dementsprechend wird das Werkzeug T in Schritt d) virtuell geöffnet, so dass das Werkstück W - ausgehend von den zuvor angepassten Elementspannungen $\sigma'_{ij}$ und der auch in der angepassten ersten Konfiguration K2' zwangsläufig vorliegenden Nullgeometrie NG - elastisch deformiert wird. Diese sich hierbei einstellende Deformation kann auch als "inverse Rückfederung", "umgekehrte Schrumpfung" oder "Wachsen" des Werkstücks W bezeichnet werden. Gegenüber der Nullgeometrie NG stellt sich in der nun vorliegenden Deformationsgeometrie DG des Werkstücks W eine Abwicklungsabweichung $\Delta\varepsilon_{MS}$ der Oberfläche des Werkstücks W ein.

Die anhand Fig. 1 gezeigte Ausführungsform des Verfahrens sieht zudem den besagten, fakultativen Schritt e) vor, der nachfolgend noch näher beschrieben wird.

Sofern der Schritt e) nicht vorgesehen sein sollte, wird nach dem Schritt d) in Schritt f) ausgehend von der zuvor ermittelten Deformationsgeometrie DG des Werkstücks W eine skalierte Wirkflächengeometrie GS des Werkzeugs T erzeugt (vgl. Fig. 13). Hierbei wird die Deformationsgeometrie DG vereinfacht ausgedrückt auf die Wirkflächengeometrie G projiziert, so dass diese in die besagte skalierte Wirkflächengeometrie GS überführt wird.

Bei der vorliegenden Ausführungsform weist die Wirkflächengeometrie G bzw. die skalierte Wirkflächengeometrie GS des Werkzeugs T unterschiedliche Bereiche, nämlich einen Blechhalterbereich B, eine Ankonstruktion A und einen Bauteilbereich BB bzw. den skalierten Bauteilbereich BBS auf. Dabei findet die Werkzeugskalierung vorliegend lediglich im Bauteilbereich BB statt. Die übrigen Bereiche werden in Angleichung an den skalierten Bauteilbereich BBS mittels grundsätzlich bekannter Verfahren tangentenstetig mitgeführt.

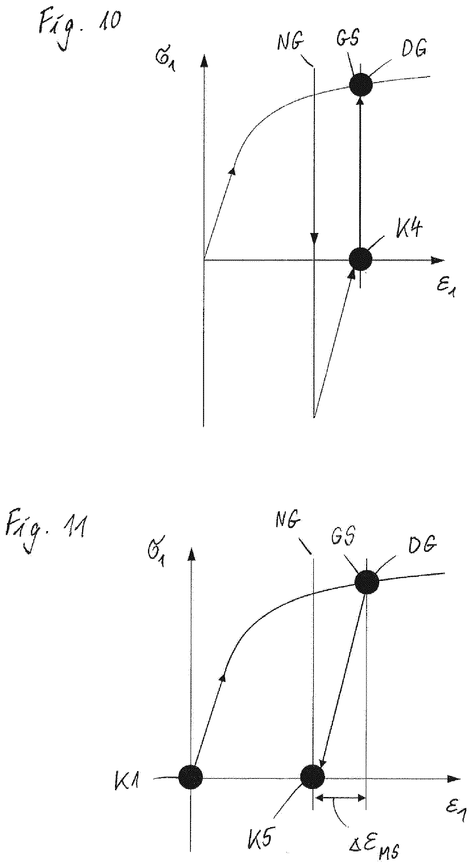

Das Erzeugen der skalierten Wirkflächengeometrie GS gemäß Schritt f) ist zusätzlich anhand Fig. 10 verdeutlicht. Dabei ist wichtig zu erwähnen, dass die Werkzeugskalierung lokal, nämlich in Abhängigkeit der jeweils lokal vorliegenden angepassten Elementspannungen $\sigma'_{ij}$ vorgenommen wird. Die Skalierung der Wirkflächengeometrie G erfolgt somit in einer über die Wirkflächengeometrie G hinweg veränderlichen, an die tatsächlich lokal vorliegende Schrumpfung angepassten Weise.

Die eigentliche Werkzeugskalierung ist somit nach Schritt f) abgeschlossen und kann einer sich fakultativ anschließenden Werkzeugkompensation zugrunde gelegt werden. So auch im vorliegenden Ausführungsbeispiel. Hierbei wird zunächst eine elastisch-plastische Umformoperation gemäß Schritt a) simuliert, wobei jedoch die zuvor erzeugte skalierte Wirkflächengeometrie GS zugrunde gelegt wird. Im geschlossenen Zustand des skalierten Werkzeugs T wird somit nicht mehr die Nullgeometrie NG eingenommen, sondern stattdessen stimmen die Deformationsgeometrie DG des Werkstücks W und die skalierte Wirkflächengeometrie GS des Werkzeugs T überein. Hiernach wird das Werkzeug T virtuell geöffnet, wodurch das Werkstück W ausgehend von der Deformationsgeometrie DG entlang der Hookeschen Geraden in eine weitere Konfiguration K5 zurückfedert. In dieser weiteren Konfiguration K5 nimmt das Werkstück W infolge der zuvor durchgeführten Werkzeugskalierung nunmehr die Nullgeometrie NG - und damit auch deren Abwicklungslängen bzw. Flächeninhalt - ein. Mit anderen Worten ausgedrückt, erfolgt ein "Schrumpfen" des Werkstücks W in die Nullgeometrie NG, so dass in der weiteren Konfiguration K5 keine Abwicklungsabweichung der Oberfläche des Werkstücks W gegenüber der Nullgeometrie mehr vorliegt.

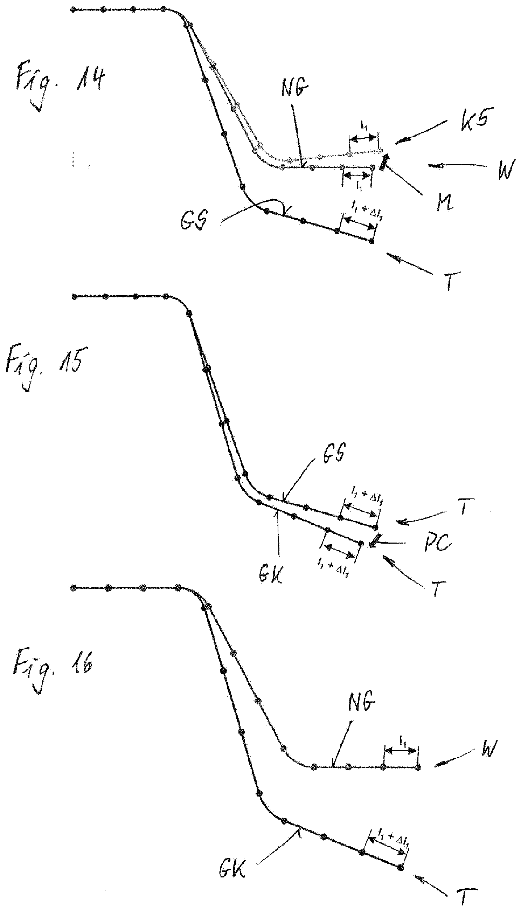

Zur weiteren Verdeutlichung wird auf die Fig. 14 bis 16 Bezug genommen. In Fig. 14 ist das Werkzeug T mit der skalierten Wirkflächengeometrie GS zusammen mit dem Werkstück W gezeigt, wobei Letzteres die bereits anhand Fig. 11 verdeutlichte weitere Konfiguration K5 einnimmt. Das Werkstück W weist in der weiteren Konfiguration K5, wie im Hinblick auf Fig. 11 erwähnt, zwar keine Abwicklungsabweichungen im Sinne einer Schrumpfung gegenüber der Nullgeometrie NG auf. Allerdings zeigt die weitere Konfiguration K5 weitere Maß- und Formabweichungen gegenüber der Nullgeometrie, die kurz als Abweichungen M bezeichnet werden. Die Abweichungen M resultieren aus elastischen Verdrehungen, Verdrillungen, Verbiegungen oder dergleichen des Werkstücks W.

Zur Kompensation der Abweichungen M wird bei der gezeigten Ausführungsform in dem Schritt g1) eine rückfederungs-kompensierte Wirkflächengeometrie GK des Werkzeugs W ermittelt. Diese Ermittlung erfolgt auf grundsätzlich bekannte Weise, nämlich unter Nutzung der sog. Physical-Compensation-Methode PC, die auch als PC-Methode bezeichnet wird und in der deutschen Offenlegungsschrift DE 10 2016 212 933 A1 ausführlich beschrieben ist. Dabei erfolgt die Kompensation mittels der PC-Methode auf Grundlage der zuvor ermittelten skalierten Wirkflächengeometrie GS. Dieser Zusammenhang ist schematisch anhand Fig. 15 verdeutlicht. Die PC-Methode ermöglicht ein "flächengleiches" Überbiegen der skalierten Wirkfläche GS, so dass die im Rahmen der Skalierung vorgenommene lokale Anpassung der Wirkflächengeometrie durch die nachgeschaltete Kompensation nicht beeinträchtigt wird. Dies ist besonders vorteilhaft. Im Ergebnis kann unter Verwendung der zunächst skalierten und hiernach kompensierten Wirkfläche auch nach elastischer Rückfederung des Werkstücks W die angestrebte Nullgeometrie NG erreicht werden (vgl. Fig. 16).

Bei einer nicht gezeigten Ausführungsform kann anstelle der Physical-Compensation-Methode eine Displacement-Adjustment-Methode oder eine Comprehensive-Compensation-Methode genutzt werden. Beide Methoden sind grundsätzlich bekannt, so dass auf weitere diesbezügliche Details nicht eingegangen werden braucht. Allerdings ist erwähnenswert, dass die beiden vorgenannten Methoden im Unterschied zu der PC-Methode kein "flächengleiches" Überbiegen der Wirkflächengeometrie G ermöglichen, was als Nachteil angesehen werden kann. Dennoch können die beiden vorgenannten Methoden in einem zu dem Schritt g1) alternativen Schritt g2) genutzt werden (vgl. Fig. 1).

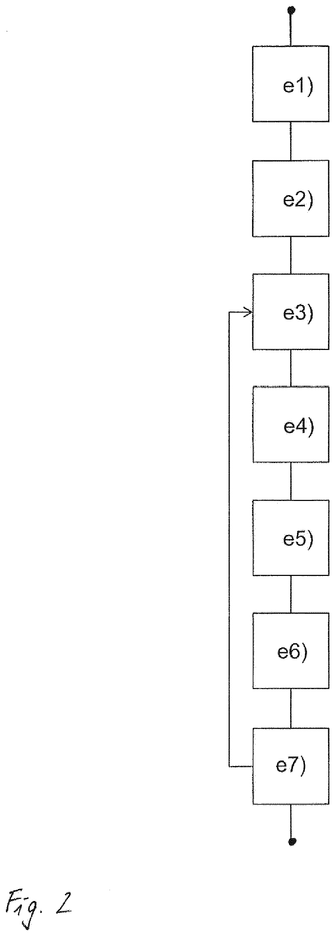

Der fakultative Verfahrensschritt e) (vgl. Fig. 1) sieht ein Korrigieren der angepassten Elementspannungen $\sigma'_{ij}$ in Abhängigkeit eines Vergleichs zwischen der ermittelten Deformationsgeometrie DG und der Rückfederungsgeometrie RG des Werkstücks W vor. Mittels dieser Korrektur soll erreicht werden, dass die jeweiligen Abwicklungsabweichungen gegenüber der Nullgeometrie NG jedenfalls betragsmäßig gleich sind. Hierdurch kann eine hinsichtlich ihrer Qualität verbesserte Werkzeugskalierung erreicht werden, was zudem Vorteile in Bezug auf die nachgeschaltete Werkzeugkompensation bieten kann. Zur weiteren Verdeutlichung der Korrektur gemäß Schritt e) wird auf Fig. 2 Bezug genommen. Dort sind Teilschritte e1) bis e7) schematisch verdeutlicht.

Der Teilschritt e1) sieht ein Simulieren einer elastischen Rückfederung des Werkstücks W ausgehend von der ersten Konfiguration K2 und ausgehend von den ermittelten, nicht angepassten - und zudem nicht über der Dicke gemittelten - Elementspannungen $\sigma_{ij}$ in eine von externer Krafteinwirkung wenigstens weitgehend freie Konfiguration, nämlich die dritte Konfiguration K3 vor. In der dritten Konfiguration K3 liegt das Werkstück W, wie bereits im Zusammenhang mit Fig. 4 erörtert, in seiner elastisch rückgefederten Rückfederungsgeometrie RG vor. Das Simulieren der elastischen Rückfederung e1) erfolgt hierbei ausgehend von der Nullgeometrie der Wirkfläche G des Werkzeugs W.

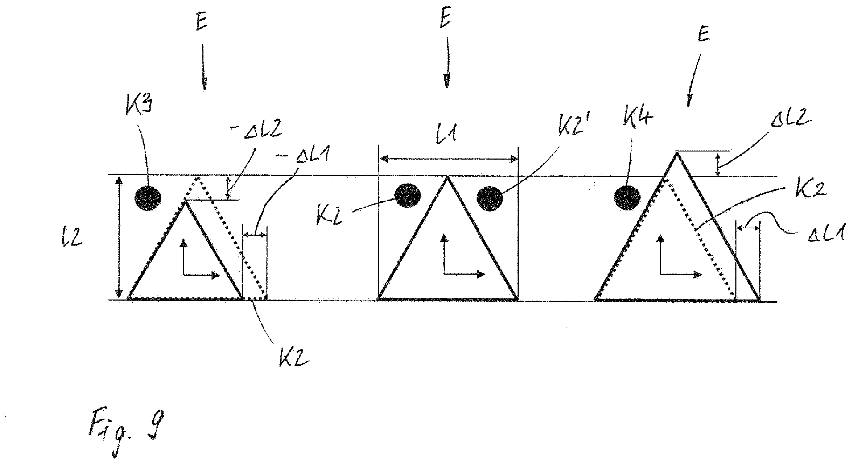

Der sich anschließende Schritt e2) sieht ein elementweises Ermitteln wenigstens einer ersten Abweichungsgröße A1 zwischen der Nullgeometrie NG und der Rückfederungsgeometrie RG vor. Als erste Abweichungsgröße A1 wird bei der gezeigten Ausführungsform die Abwicklungsabweichung $\Delta\varepsilon_{RF}$ verwendet. Hierzu wird auch auf Fig. 9 Bezug genommen. Dort ist ein exemplarisches Element E der Finite-Elemente-Diskretisierung FE des Werkstücks W gezeigt. Das Element E ist in unterschiedlichen Konfigurationen, nämlich der elastisch rückgefederten dritten Konfiguration K3, in der die Rückfederungsgeometrie RG eingenommen wird, der ersten Konfiguration K2 bzw. der (angepassten) ersten Konfiguration K2', in der die Nullgeometrie eingenommen wird und der zweiten Konfiguration K4, in der die Deformationsgeometrie DG eingenommen wird, gezeigt. Das Element E weist in Bezug auf die nicht näher bezeichneten lokalen Koordinatenachsen in der Nullgeometrie NG und damit in der ersten Konfiguration K2 eine Länge l1 und eine Höhe l2 auf. In der dritten Konfiguration K3 liegt das Element E in Bezug auf die Nullgeometrie NG in geschrumpfter und somit längen- und höhenmäßig verkürzter Form vor. In Bezug auf die Elementhöhe ergibt sich eine exemplarische Schrumpfung von -Δl2; in Bezug auf die Elementlänge ergibt sich eine exemplarische Schrumpfung von -Δl1. Die wenigstens eine erste Abweichungsgröße A1 ist vorliegend als $\Delta\varepsilon_{RF} = \Delta l1 / l1$ bestimmt. Es versteht sich, dass in Bezug auf die Elementhöhe in entsprechender Weise eine weitere Abweichungsgröße bestimmt werden kann.

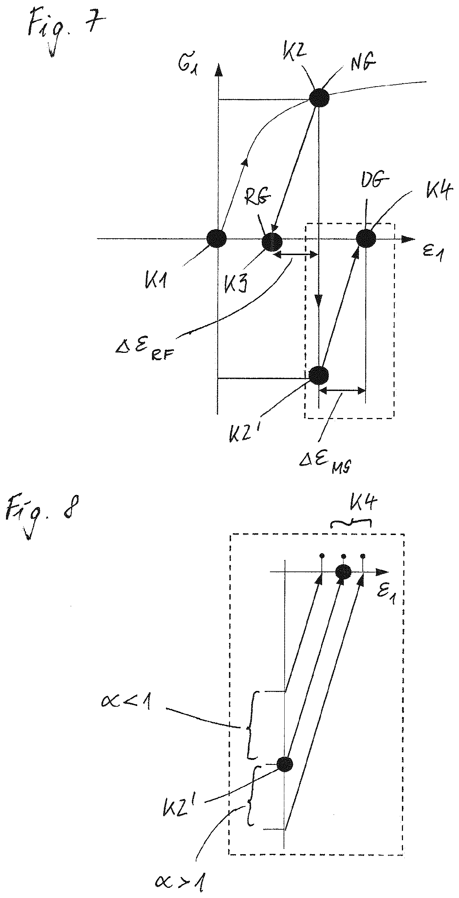

Der sich anschließende Teilschritt e3) sieht ein elementweises Ermitteln einer zweiten Abweichungsgröße A2 zwischen der Nullgeometrie NG und der Deformationsgeometrie DG vor. Die zweite Abweichungsgröße A2 ist vorliegend als Abwicklungsabweichung $\Delta\varepsilon_{MS}$ definiert (vgl. Fig. 7). Hierzu wird wiederum auf Fig. 9 Bezug genommen. Die zweite Abweichungsgröße A2 wird in einer zu der ersten Abweichungsgröße A1 entsprechenden Weise und auf Grundlage des sich in der zweiten Konfiguration K4 einstellenden "Wachstums" des Elements E bestimmt.

Der sich weiter anschließende Teilschritt e4) sieht ein elementweises Ermitteln eines Korrekturfaktors $\alpha$ in Abhängigkeit der ersten Abweichungsgröße A1 und der zweiten Abweichungsgröße A2 vor. Der Korrekturfaktor $\alpha$ ist bei der gezeigten Ausführungsform als Verhältnis zwischen der ersten Abweichungsgröße A1 und der zweiten Abweichungsgröße A2 definiert. Vereinfacht ausgedrückt gibt der Korrekturfaktor $\alpha$ das Verhältnis zwischen "Schrumpfung" und "Wachstum" des Elements E an. Sofern diese betragsmäßig identisch zueinander sind, gilt $\alpha = 1$. Andernfalls gilt $\alpha < 1$ oder $\alpha > 1$ (vgl. Fig. 8).

Der sich anschließende Teilschritt e5) sieht ein elementweises Korrigieren der angepassten Elementspannungen $\sigma'_{ij}$ vor, wobei die angepassten, in ihren Vorzeichen umgekehrten Membranspannungskomponenten $\sigma'_{11}$, $\sigma'_{22}$, $\sigma'_{12}$ und $\sigma'_{21}$ mit dem jeweils ermittelten Korrekturfaktor $\alpha$ multipliziert werden. Diese Korrektur erfolgt in der (angepassten) ersten Konfiguration K2'. Die Korrektur dient einer betragsmäßigen Angleichung des Elementwachstums im Verhältnis zur Elementschrumpfung.

Der sich anschließende Teilschritt e6) sieht ein erneutes Simulieren der elastischen Deformation gemäß Schritt d) vor, wobei die sich einstellende elastische Deformation ausgehend von den gemäß Schritt e5) korrigierten Elementspannungen erfolgt. Dies ist anhand Fig. 8 verdeutlicht. Je nachdem, ob der Korrekturfaktor $\alpha$ kleiner oder größer 1 ist, ergibt sich nach Durchlaufen des Teilschritts e6) in der dritten Konfiguration K4 eine dementsprechend korrigierte Abwicklungsabweichung.

Bei der gezeigten Ausführungsform werden die Teilschritte e3) bis e6) iterativ durchlaufen, wobei in einem sich an den Teilschritt e6) anschließenden Teilschritt e7) das Erreichen eines Konvergenzkriteriums abgeprüft wird. Als Konvergenzkriterium wird bei der gezeigten Ausführungsform der Korrekturfaktor $\alpha$ selbst verwendet, so dass die Iteration dann beendet wird, wenn für den Betrag des Korrekturfaktors $\alpha$ ein Wert von 1,00 erreicht wird. Bei einer nicht gezeigten Ausführungsform kann die Iteration stattdessen nach Erreichen einer vorbestimmten Anzahl von Iterationen abgebrochen werden.

An den Teilschritt e7) schließt sich nach Beenden der Iteration der bereits beschriebene Schritt f) des Verfahrens nach Fig. 1 an.

**Patentansprüche**

1. Computergestütztes Verfahren zur Herstellung eines Umformwerkzeugs (TR) mit einer rückfederungs-skalierten Wirkfläche zur Herstellung eines komplexen Umformteils (U) durch ziehtechnisches Umformen mittels folgender Schritte:

    a) Simulieren wenigstens einer elastisch-plastischen Formänderungsoperation mittels einer Diskretisierungsmethode, insbesondere einer Finite-Elemente-Methode, wobei ein diskretisiertes, insbesondere finite-elemente-diskretisiertes, Werkstück (W), welches das Umformteil (U) repräsentiert, mittels einer Einwirkung wenigstens eines Werkzeugs (T), welches das Umformwerkzeug (TR) repräsentiert, in eine erste Konfiguration (K2) elastisch-plastisch umgeformt wird, wobei das wenigstens eine Werkzeug (T) eine zur Einwirkung auf das Werkstück (W) vorgesehene Wirkflächengeometrie (G) aufweist, die eine Nullgeometrie (NG) der Wirkfläche des Umformwerkzeugs (TR) repräsentiert, und wobei in der ersten Konfiguration (K2) die Einwirkung des wenigstens einen Werkzeugs (T) auf das Werkstück (W) beibehalten wird und somit eine elastische Rückfederung des Werkstücks (W) unterbunden wird;
    b) Ermitteln von in der ersten Konfiguration (K2) vorliegenden lokalen Spannungen ($\sigma_{ij}$) des Werkstücks (W);
    c) Anpassen der ermittelten lokalen Spannungen ($\sigma_{ij}$) nach Vorzeichen und/oder Betrag, wobei die Vorzeichen der jeweiligen Membranspannungskomponenten ($\sigma_{11}$, $\sigma_{22}$, $\sigma_{12}$, $\sigma_{21}$) der ermittelten lokalen Spannungen ($\sigma_{ij}$) umgekehrt werden, die Beträge der jeweiligen übrigen Spannungskomponenten ($\sigma_{13}$, $\sigma_{23}$, $\sigma_{31}$, $\sigma_{32}$, $\sigma_{33}$) der ermittelten lokalen Spannungen ($\sigma_{ij}$) verringert werden;
    d) Simulieren einer elastischen Deformation des Werkstücks (W) ausgehend von der ersten Konfiguration (K2) und ausgehend von den angepassten lokalen Spannungen ($\sigma'_{ij}$) in eine von externer Krafteinwirkung freie zweite Konfiguration (K4), wobei eine in der zweiten Konfiguration (K4) vorliegende elastisch deformierte Deformationsgeometrie (DG) des Werkstücks (W) ermittelt wird; und
    f) Erzeugen einer skalierten Wirkflächengeometrie (GS) des Werkzeugs (T) in Abhängigkeit der ermittelten Deformationsgeometrie (DG) des Werkstücks (W).

2. Computergestütztes Verfahren nach Anspruch 1, wobei der Schritt c) umfasst: Verringern der Beträge der übrigen Spannungskomponenten ($\sigma_{13}$,$\sigma_{23}$,$\sigma_{31}$, $\sigma_{32}$,$\sigma_{33}$) mittels Multiplikation mit einem Faktor kleiner als $10^{-1}$, bevorzugt kleiner als $10^{-4}$, besonders bevorzugt kleiner als $10^{-16}$.

3. Computergestütztes Verfahren nach Anspruch 1 oder 2, umfassend den Schritt:
    e) Korrigieren der angepassten lokalen Spannungen ($\sigma'_{ij}$) in Abhängigkeit eines Vergleichs zwischen der ermittelten Deformationsgeometrie (DG) und einer Rückfederungsgeometrie (RG) des Werkstücks (W).

4. Computergestütztes Verfahren nach Anspruch 3, wobei der Schritt e) umfasst:

    e1) Simulieren einer elastischen Rückfederung des Werkstücks (W) ausgehend von der ersten Konfiguration (K2) und ausgehend von den ermittelten, nicht angepassten lokalen Spannungen ($\sigma_{ij}$) in eine von externer Krafteinwirkung wenigstens weitgehend freie dritte Konfiguration (K3), wobei die in der dritten Konfiguration (K3) vorliegende elastisch deformierte Rückfederungsgeometrie (RG) des Werkstücks (W) ermittelt wird;
    e2) Ermitteln wenigstens einer ersten Abweichungsgröße (A1) zwischen der Nullgeometrie (NG) und der Rückfederungsgeometrie (RG);
    e3) Ermitteln wenigstens einer zweiten Abweichungsgröße (A2) zwischen der Nullgeometrie (NG) und der Deformationsgeometrie (DG);
    e4) Ermitteln wenigstens eines Korrekturfaktors ($\alpha$) in Abhängigkeit der ersten Abweichungsgröße (A1) und der zweiten Abweichungsgröße (A2);
    e5) Korrigieren der angepassten lokalen Spannungen ($\sigma'_{ij}$) in der ersten Konfiguration (K2), wobei die angepassten, in ihren Vorzeichen umgekehrten Membranspannungskomponenten ($\sigma'_{11}, \sigma'_{22}, \sigma'_{12}, \sigma'_{21}$) mit dem jeweils ermittelten Korrekturfaktor ($\alpha$) multipliziert werden; wobei das Ermitteln in den Schritten e2), e3), e4) und das Korrigieren in Schritt e5) in Kollokationspunkten der verwendeten Diskretisierung, insbesondere elementweise, erfolgt; und
    e6) erneutes Simulieren der elastischen Deformation gemäß Schritt d) und ausgehend von den gemäß Schritt e5) korrigierten lokalen Spannungen.

5. Computergestütztes Verfahren nach Anspruch 4, worin die Schritte e3) bis e6) iterativ durchlaufen werden bis zum Erreichen eines in Abhängigkeit des Korrekturfaktors ($\alpha$) gebildeten Konvergenzkriteriums und/oder einer maximalen Anzahl an Iterationen.

6. Computergestütztes Verfahren nach Anspruch 5, **dadurch gekennzeichnet, dass** die Iteration dann beendet wird, wenn der Betrag des Korrekturfaktors ($\alpha$) 1,00 beträgt.

7. Computergestütztes Verfahren nach einem der Ansprüche 1 bis 6, umfassend den Schritt:
g1) Ermitteln einer rückfederungs-kompensierten Wirkflächengeometrie (GK) des Werkzeugs (W) auf Grundlage der zuvor erzeugten skalierten Wirkflächengeometrie (GS), wobei eine Physical-Compensation-Methode (PC) verwendet wird.

8. Computergestütztes Verfahren nach einem der Ansprüche 1 bis 6, umfassend den Schritt:
g2) Ermitteln einer rückfederungs-kompensierten Wirkflächengeometrie (GK) des Werkzeugs (W) auf Grundlage der zuvor erzeugten skalierten Wirkflächengeometrie (GS), wobei eine Displacement-Adjustment-Methode und/oder eine Comprehensive-Compensation-Methode verwendet wird.

9. Computergestütztes Verfahren nach einem der vorhergehenden Ansprüche, umfassend die Schritte:
Ermitteln einer Wirkflächengeometrie-Spezifikation für die Wirkfläche des Umformwerkzeugs (TR) in Abhängigkeit der erzeugten skalierten Wirkflächengeometrie (GS) des Werkzeugs (T); und Herstellen des Umformwerkzeugs (TR) mittels Erzeugens der Wirkfläche gemäß der Wirkflächengeometrie-Spezifikation.

10. Computergestütztes Verfahren nach Anspruch 9, umfassend den Schritt: Herstellen des komplexen Umformteils (U) durch ziehtechnisches Umformen unter Verwendung des hergestellten Umformwerkzeugs (TR).

11. Computerprogrammprodukt, welches insbesondere auf einem computerlesbaren Medium gespeichert ist, wobei das Computerprogrammprodukt, wenn es in dem Speicher eines geeigneten Computers geladen und ausgeführt wird, bewirkt, dass der Computer ein Verfahren nach einem der Ansprüche 1 bis 8 ausführt.

**Claims**

1. Computer-aided method for producing a forming tool (TR) with a springback-scaled active surface for producing a complex formed part (U) by performing a drawing type of forming process by means of the following steps:

a) simulating at least one elastic-plastic shape-changing operation by means of a discretizing method, in particular a finite-element method, wherein a discretized, in particular finite-element discretized, workpiece (W), which represents the formed part (U), is formed elastically-plastically into a first configuration (K2) by means of an effect of at least one tool (T), which represents the forming tool (TR), wherein the at least one tool (T) has an active-surface geometry (G), which is intended for imparting the effect on the workpiece (W) and represents a zero geometry (NG) of the active surface of the forming tool (TR), and wherein, in the first configuration (K2), the effect of the at least one tool (T) on the workpiece (W) is maintained and therefore an elastic springback of the workpiece (W) is prevented;
b) determining local stresses ($\sigma_{ij}$) of the workpiece (W) present in the first configuration (K2);
c) adapting the determined local stresses ($\sigma_{ij}$) in terms of their sign and/or amount, wherein the signs of the respective membrane stress components ($\sigma_{11}$, $\sigma_{22}$, $\sigma_{12}$, $\sigma_{21}$) of the determined local stresses ($\sigma_{ij}$) are inverted, the amounts of the respective remaining stress components ($\sigma_{13}$, $\sigma_{23}$, $\sigma_{31}$, $\sigma_{32}$, $\sigma_{33}$) of the determined local stresses ($\sigma_{ij}$) are reduced;
d) simulating an elastic deformation of the workpiece (W) from the first configuration (K2) and from the adapted local stresses ($\sigma'_{ij}$) into a second configuration (K4) free of any external force effect, wherein an elastically deformed deformation geometry (DG) of the workpiece (W) present in the second configuration (K4) is determined; and
f) generating a scaled active-surface geometry (GS) of the tool (T) in dependence on the determined deformation geometry (DG) of the workpiece (W).

2. Computer-aided method according to Claim 1, wherein step c) comprises: reducing the amounts of the remaining stress components ($\sigma_{13}$, $\sigma_{23}$, $\sigma_{31}$, $\sigma_{32}$, $\sigma_{33}$) by means of multiplication by a factor less than $10^{-1}$, preferably less than $10^{-4}$, particularly preferably less than $10^{-16}$.

3. Computer-aided method according to Claim 1 or 2, comprising the step of:
e) correcting the adapted local stresses ($\sigma'_{ij}$) in dependence on a comparison between the determined deformation geometry (DG) and a springback geometry (RG) of the workpiece (W).

**4.** Computer-aided method according to Claim 3, wherein step e) comprises:

e1) simulating an elastic springback of the workpiece (W) from the first configuration (K2) and from the determined, non-adapted local stresses ($\sigma_{ij}$) into a third configuration (K3) at least largely free of any external force effect, wherein the elastically deformed springback geometry (RG) of the workpiece (W) present in the third geometry (K3) is determined;

e2) determining at least one first deviation variable (A1) between the zero geometry (NG) and the springback geometry (RG);

e3) determining at least one second deviation variable (A2) between the zero geometry (NG) and the deformation geometry (DG);

e4) determining at least one correction factor ($\alpha$) in dependence on the first deviation variable (A1) and the second deviation variable (A2);

e5) correcting the adapted local stresses ($\sigma'_{ij}$) in the first configuration (K2), wherein the adapted membrane stress components ($\sigma'_{11}$, $\sigma'_{22}$, $\sigma'_{12}$, $\sigma'_{21}$), inverted in their signs, are multiplied by the respectively determined correction factor ($\alpha$); wherein the determination in steps e2), e3), e4) and the correction in step e5) take place at collocation points of the discretization used, in particular element by element; and

e6) re-simulating the elastic deformation according to step d) and from the local stresses corrected according to step e5).

**5.** Computer-aided method according to Claim 4, in which steps e3) to e6) are performed iteratively until a convergence criterion, formed in dependence on the correction factor ($\alpha$), and/or a maximum number of iterations is reached.

**6.** Computer-aided method according to Claim 5, **characterized in that** the iteration is ended when the amount of the correction factor ($\alpha$) is 1.00.

**7.** Computer-aided method according to one of Claims 1 to 6, comprising the step of:
g1) determining a springback-compensated active-surface geometry (GK) of the tool (W) on the basis of the previously generated scaled active-surface geometry (GS), wherein a physical compensation method (PC) is used.

**8.** Computer-aided method according to one of Claims 1 to 6, comprising the step of:
g2) determining a springback-compensated active-surface geometry (GK) of the tool (W) on the basis of the previously generated scaled active-surface geometry (GS), wherein a displacement adjustment method and/or a comprehensive compensation method is used.

**9.** Computer-aided method according to one of the preceding claims, comprising the steps of: determining an active-surface geometry specification for the active surface of the forming tool (TR) in dependence on the generated scaled active-surface geometry (GS) of the tool (T); and producing the forming tool (TR) by means of generating the active surface according to the active-surface geometry specification.

**10.** Computer-aided method according to Claim 9, comprising the step of: producing the complex formed part (U) by performing a drawing type of forming process using the forming tool (TR) produced.

**11.** Computer program product, which in particular is stored on a computer-readable medium, wherein, when it is loaded in a suitable computer and is executed, the computer program product causes the computer to perform a method according to one of Claims 1 to 8.

**Revendications**

**1.** Procédé assisté par ordinateur pour la fabrication d'un outil de formage (TR) avec une surface active mise à l'échelle en fonction du retour élastique pour la fabrication d'une pièce de formage complexe (U) par formage par emboutissage, au moyen des étapes suivantes :

a) la simulation d'au moins une opération de modification de forme élastoplastique au moyen d'une méthode de discrétisation, notamment d'une méthode par éléments finis, où une pièce discrétisée (W), notamment discrétisée par éléments finis, qui représente la pièce de formage (U), est déformée de manière élastoplastique dans une première configuration (K2) au moyen d'une action d'au moins un outil (T) représentant l'outil de formage (TR), l'au moins un outil (T) présentant une géométrie de surface active (G) prévue pour agir sur la pièce (W), qui représente une géométrie nulle (NG) de la surface active de l'outil de formage (TR), et où, dans la première configuration (K2), l'action de l'au moins un outil (T) sur la pièce (W) est maintenue, et un retour élastique de la pièce (W) est ainsi empêché ;

b) la détermination des contraintes locales ($\sigma_{ij}$) de la pièce (W) présentes dans la première configuration (K2) ;

c) l'ajustement des contraintes locales déterminées ($\sigma_{ij}$) en fonction du signe et/ou de la valeur, les signes des composantes de contrainte de membrane respectives ($\sigma_{11}$, $\sigma_{22}$, $\sigma_{12}$, $\sigma_{21}$) des

contraintes locales déterminées ($\sigma_{ij}$) étant inversés, les valeurs des composantes de contrainte restantes respectives ($\sigma_{13}$, $\sigma_{23}$, $\sigma_{31}$, $\sigma_{32}$, $\sigma_{33}$) des contraintes locales déterminées ($\sigma_{ij}$) étant réduites ;

d) la simulation d'une déformation élastique de la pièce (W) à partir de la première configuration (K2) et à partir des contraintes locales ajustées ($\sigma'_{ij}$) dans une deuxième configuration (K4) libre de toute force externe, une géométrie de déformation déformée élastiquement (DG) de la pièce (W) présente dans la deuxième configuration (K4) étant déterminée ; et

f) la création d'une géométrie de surface active mise à l'échelle (GS) de l'outil (T) en fonction de la géométrie de déformation déterminée (DG) de la pièce (W).

2. Procédé assisté par ordinateur selon la revendication 1, dans lequel l'étape c) comprend : la réduction des valeurs des autres composantes de contrainte ($\sigma_{13}$, $\sigma_{23}$, $\sigma_{31}$, $\sigma_{32}$, $\sigma_{33}$) en les multipliant par un facteur inférieur à $10^{-1}$, de préférence inférieur à $10^{-4}$, et de manière particulièrement préférée inférieur à $10^{-16}$.

3. Procédé assisté par ordinateur selon la revendication 1 ou 2, comprenant l'étape suivante :
e) la correction des contraintes locales ajustées ($\sigma'_{ij}$) en fonction d'une comparaison entre la géométrie de déformation déterminée (DG) et une géométrie de retour élastique (RG) de la pièce (W).

4. Procédé assisté par ordinateur selon la revendication 3, dans lequel l'étape e) comprend :

e1) la simulation d'un retour élastique de la pièce (W) à partir de la première configuration (K2) et à partir des contraintes locales non ajustées déterminées ($\sigma_{ij}$) dans une troisième configuration (K3) au moins largement exempte de l'action de forces externes, la géométrie de retour élastique (RG) déformée élastiquement de la pièce (W) présente dans la troisième configuration (K3) étant déterminée ;
e2) la détermination d'au moins une première grandeur d'écart (A1) entre la géométrie nulle (NG) et la géométrie de retour élastique (RG) ;
e3) la détermination d'au moins une deuxième grandeur d'écart (A2) entre la géométrie nulle (NG) et la géométrie de déformation (DG) ;
e4) la détermination d'au moins un facteur de correction ($\alpha$) en fonction de la première grandeur d'écart (A1) et de la deuxième grandeur d'écart (A2) ;
e5) la correction des contraintes locales ajustées ($\sigma'_{ij}$) dans la première configuration (K2), les composantes de contrainte de membrane ajustées, inversées dans leur signe ($\sigma'_{11}$, $\sigma'_{22}$, $\sigma'_{12}$, $\sigma'_{21}$) étant multipliées par le facteur de correction ($\alpha$) déterminé dans chaque cas ;
la détermination dans les étapes e2), e3), e4) et la correction dans l'étape e5) s'effectuant dans des points de collocation de la discrétisation utilisée, notamment élément par élément ; et
e6) la nouvelle simulation de la déformation élastique selon l'étape d) et à partir des contraintes locales corrigées selon l'étape e5).

5. Procédé assisté par ordinateur selon la revendication 4, dans lequel les étapes e3) à e6) sont exécutées de manière itérative jusqu'à ce qu'un critère de convergence formé en fonction du facteur de correction ($\alpha$) et/ou un nombre maximal d'itérations soient atteints.

6. Procédé assisté par ordinateur selon la revendication 5, **caractérisé en ce que** l'itération est terminée lorsque la valeur du facteur de correction ($\alpha$) est égale à 1,00.

7. Procédé assisté par ordinateur selon l'une quelconque des revendications 1 à 6, comprenant l'étape suivante :
g1) la détermination d'une géométrie de surface active compensée en termes de retour élastique (GK) de l'outil (W) sur la base de la géométrie de surface active mise à l'échelle (GS) générée précédemment, une méthode de compensation physique (PC) étant utilisée.

8. Procédé assisté par ordinateur selon l'une quelconque des revendications 1 à 6, comprenant l'étape suivante :
g2) la détermination d'une géométrie de surface active compensée en termes de retour élastique (GK) de l'outil (W) sur la base de la géométrie de surface active mise à l'échelle (GS) générée précédemment, une méthode d'ajustement de déplacement et/ou une méthode de compensation globale étant utilisée.

9. Procédé assisté par ordinateur selon l'une quelconque des revendications précédentes, comprenant les étapes suivantes : la détermination d'une spécification de géométrie de surface active pour la surface active de l'outil de formage (TR) en fonction de la géométrie de surface active mise à l'échelle (GS) générée de l'outil (T) ; et la fabrication de l'outil de formage (TR) en générant la surface active selon la spécification de géométrie de surface active.

10. Procédé assisté par ordinateur selon la revendication 9, comprenant l'étape suivante : la fabrication de la pièce de formage complexe (U) par formage par emboutissage à l'aide de l'outil de formage (TR) fabriqué.

11. Produit de programme informatique, notamment stocké sur un support lisible par ordinateur, le produit de programme informatique, lorsqu'il est chargé et exécuté dans la mémoire d'un ordinateur approprié, amenant l'ordinateur à exécuter un procédé selon l'une quelconque des revendications 1 à 8.

Fig. 1

Fig. 2

Fig. 3

Fig. 4

Fig. 5

$$\sigma = \begin{pmatrix} \sigma_{11} & \sigma_{12} & \sigma_{13} \\ \sigma_{21} & \sigma_{22} & \sigma_{23} \\ \sigma_{31} & \sigma_{32} & \sigma_{33} \end{pmatrix}$$

$$\sigma' = \begin{pmatrix} \sigma'_{11} & \sigma'_{12} & \sim 0 \\ \sigma'_{21} & \sigma'_{22} & \sim 0 \\ \sim 0 & \sim 0 & \sim 0 \end{pmatrix}$$

Fig. 6

Fig. 7

Fig. 8

Fig. 9

Fig. 10

Fig. 11

Fig. 12

Fig. 13

Fig. 14

Fig. 15

Fig. 16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016212933 A1

**In der Beschreibung aufgeführte Nicht-Patentliteratur**

- **A. BIRKEIT** ; **S. HAAGE** ; **M. STRAUB**. Umformtechnische Herstellung komplexer Karosserieteile - Auslegung von Ziehanlagen. Springer Vieweg-Verlag, 2013
- **R. A. LINGBEEK et al.** Theoretical verification of the displacement adjustment and spring forward algorithms for springback compensation. *Int J Mater Form*, 2008, vol. 1, 159-168
- **YANG XIANG AN et al.** A die design method for springback compensation based on displacement adjustment. *International Journal of Mechanical Sciences*, 01 May 2011, vol. 53 (5), 399-406